# EUROPEAN PATENT APPLICATION

(11) **EP 2 899 891 A1**
(43) Date of publication of application: **29.07.2015**
(21) Application number: 13845425.1
(22) Date of filing: 09.09.2013
(51) Int. Cl.: H04B 1/18, H03G 3/20

(54) **DOWN-CONVERSION DEVICE AND REALIZING METHOD THEREOF AND RECEIVER**

(30) Priority: 10.10.2012 CN 201210381339
(71) Applicant: ZTE Corporation, Shenzhen, Guangdong 518057 (CN)
(72) Inventor: DUAN, Yajuan, Shenzhen Guangdong 518057 (CN); LI, Xiangling, Shenzhen Guangdong 518057 (CN); ZHANG, Guojun, Shenzhen Guangdong 518057 (CN)
(74) Representative: Reichert & Lindner Partnerschaft Patentanwälte
(86) International application number: PCT/CN2013/083154
(87) International publication number: WO 2014/056379

(57) **Abstract**

A down-conversion device applied in a receiver and a realizing method thereof are described, which relate to the field of mobile communication. The down-conversion device for down-converting a first radio frequency signal received by a receiver antenna includes a control module configured to output a control signal according to the power of the first radio frequency signal, a gain processing module configured to amplify the gain or attenuate the power of the first radio frequency signal according to the control signal to obtain a second radio frequency signal, and a down-conversion module configured to down-convert the second radio frequency signal to an intermediate frequency and output an intermediate frequency signal. In this way, it can be dynamically decided whether to amplify the gain or attenuate the gain of radio frequency signals according to the power of different radio frequency signals received, so as to avoid attenuating a radio frequency signal before amplifying it and reduce the power consumption of the receiver.

## Description

### TECHNICAL FIELD

The disclosure relates to the field of mobile communication, and in particular to a down-conversion device applied in a receiver and a realizing method thereof.

### BACKGROUND

With the development of communication, multimode application of a product and increase of the number of carriers supported by a product have become the main design goals of the current communication technology. In order to apply multi-communication standards harmoniously, the performance of a component is required to satisfy the most rigorous requirement in circuit design of radio frequency hardware.

In a multimode system, different standard has different requirement on linearity of a receiver. In order to satisfy the requirement of multimode, a conventional receiver is needed to be designed in accordance with the most rigorous requirement. The conventional receiver consists mainly of a gain attenuation unit, a gain amplification unit and a down-conversion module having conversion gain. When a multimode system simultaneously involves standards such as Long Term Evolution (LTE) and Global System of Mobile communication (GSM), since the GSM standard has a higher requirement on a dynamic gain range and linearity index of a receiver than other standard, a receiver shall be designed in accordance with the requirement of the GSM standard, and the gain attenuation unit causes a larger attenuation to a radio frequency signal. When a receiver is used in a standard such as LTE which requires a lower linearity, after the gain attenuation unit attenuates the gain of an input radio frequency signal, it is further needed to amplify the gain of the attenuated radio frequency signal using a gain amplification unit. Thus, the attenuation before amplification not only results in a waste of gain, but also increases the power consumption of a receiver.

### SUMMARY

In view of the above, the technical problem to be solved by the disclosure is to provide a down-conversion device and a realizing method thereof to reduce the power consumption of a receiver.

In order to solve the above technical problem, an embodiment of the disclosure provides the following technical solutions.

An embodiment of the disclosure provides a down-conversion device for down-converting a first radio frequency signal received by a receiver antenna, comprising:
a control module, configured to output a control signal according to power of the first radio frequency signal;
a gain processing module, configured to amplify the gain of the first radio frequency signal or attenuate the power of the first radio frequency signal according to the control signal, to obtain a second radio frequency signal; and
a down-conversion module, configured to down-convert the second radio frequency signal to an intermediate frequency and output an intermediate frequency signal.

In an embodiment, the down-conversion device may further include:
an image frequency improvement module, configured to filter the second radio frequency signal;
the down-conversion module, further configured to down-convert a signal output from the image frequency improvement module to an intermediate frequency, and output an intermediate frequency signal.

In an embodiment, the gain processing module may include:
a gain amplification module, configured to amplify the gain of the first radio frequency signal or directly output the first radio frequency signal according to the control signal;
a gain attenuation module, configured to attenuate the power of a signal output from the gain amplification module according to the control signal.

In an embodiment, the control module may be configured to output a first control signal to the gain processing module when the power of the first radio frequency signal is larger than a preset threshold;
the gain amplification module may be configured to directly output the first radio frequency signal to the gain attenuation module according to the first control signal;
the gain attenuation module may be configured to attenuate the power of the first radio frequency signal according to preset attenuation.

In an embodiment, the control module may be configured to output a second control signal to the gain processing module when the power of the first radio frequency signal is not larger than a preset threshold;
the gain amplification module may be configured to amplify the gain of the first radio frequency signal by a preset multiple according to the second control signal;
the gain attenuation module may be configured to attenuate by 0dB the power of the signal output from the gain amplification module.

An embodiment of the disclosure further provides a receiver including the aforementioned down-conversion device for down-converting a radio frequency signal received by a receiver antenna.

An embodiment of the disclosure further provides a realizing method of down-conversion, which is for down-converting a first radio frequency signal received by a receiver antenna and includes that:
a down-conversion device detects power of a first radio frequency signal received by a receiver antenna;
the down-conversion device amplifies the gain of the first radio frequency signal or attenuates the power of the first radio frequency signal according to the power of the first radio frequency signal, to obtain a second radio frequency signal;
the down-conversion device down-converts the second radio frequency signal to an intermediate frequency and outputs an intermediate frequency signal.

In an embodiment, before the down-conversion device down-converts the second radio frequency signal to an intermediate frequency, the method may further include:
the down-conversion device filters the second radio frequency signal.

In an embodiment, the step that the down-conversion device amplifies the gain of the first radio frequency signal or attenuates the power of the first radio frequency signal according to the power of the first radio frequency signal to obtain the second radio frequency signal may include:
when the power of the first radio frequency signal is larger than a preset threshold, the down-conversion device attenuates the power of the first radio frequency signal according to preset attenuation, to obtain the second radio frequency signal.

In an embodiment, the step that the down-conversion device amplifies the gain of the first radio frequency signal or attenuates the power of the first radio frequency signal according to the power of the first radio frequency signal to obtain the second radio frequency signal may include:
when the power of the first radio frequency signal is not larger than a preset threshold, the down-conversion device amplifies the gain of the first radio frequency signal by a preset multiple, to obtain the second radio frequency signal.

The embodiments of the disclosure include the following advantageous effects:
when the requirement of a multi-standard system is satisfied, whether to amplify or attenuate the gain of radio frequency signals can be dynamically decided according to the power of different radio frequency signals received, thereby avoiding attenuating a radio frequency signal before amplifying it, and reducing the power consumption of a receiver.

### BRIEF DESCRIPTION OF THE DRAWINGS

Fig. 1 is a schematic diagram of a composition structure of a down-conversion device according to an embodiment of the disclosure;
Fig. 2 is a flow chart of a realizing method of down-conversion according to embodiment 1 of the disclosure;
Fig. 3 is a flow chart of a realizing method of down-conversion according to embodiment 2 of the disclosure; and
Fig. 4 is a schematic diagram when a down-conversion device is applied to a frequency division duplexing system and a time division duplexing system according to an embodiment of the disclosure.

### DETAILED DESCRIPTION

To clearly show a technical problem to be solved, a technical solution, and beneficial effects of embodiments of the disclosure, the present disclosure is further elaborated below with reference to the drawings and embodiments.

To solve the problem in the related art that attenuation carried out before amplification not only results in a waste of gain but also increases the power consumption of a receiver in a multimode system, the embodiments of the disclosure provide a down-conversion device capable of reducing the power consumption of a receiver, and a realizing method thereof and a receiver.

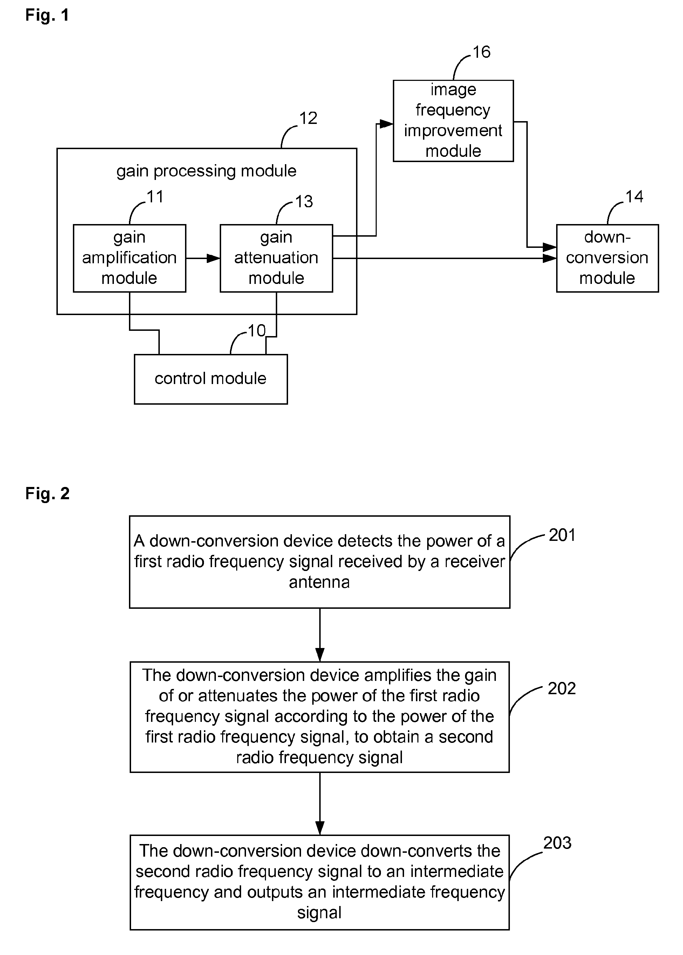

Fig. 1 is a schematic diagram of a composition structure of a down-conversion device according to an embodiment of the disclosure. As shown in Fig. 1, the down-conversion device includes:
a control module 10 configured to output a control signal according to the power of a first radio frequency signal;
a gain processing module 12 configured to amplify the gain of or attenuate the power of the first radio frequency signal according to the control signal, to obtain a second radio frequency signal; and
a down-conversion module 14 configured to down-convert the second radio frequency signal to an intermediate frequency and output an intermediate frequency signal.

In the embodiment, as shown in Fig. 1, the down-conversion device may further include:
an image frequency improvement module 16 configured to filter the second radio frequency signal output from the gain processing module 12;
a down-conversion module 14 further configured to down-convert a signal output from the image frequency improvement module 16 to an intermediate frequency, and output an intermediate frequency signal.

As shown in Fig. 1, the gain processing module 12 may include:
a gain amplification module 11 configured to amplify the gain of the first radio frequency signal or directly output the first radio frequency signal according to the control signal;
a gain attenuation module 13 configured to attenuate the power of a signal output from the gain amplification module 11 according to the control signal.

Wherein, the control module 10 is configured to output a first control signal to the gain processing module 12 when the power of the first radio frequency signal is larger than a preset threshold;
the gain amplification module 11 is configured to directly output the first radio frequency signal to the gain attenuation module 13 according to the first control signal;
the gain attenuation module 13 is configured to attenuate the power of the first radio frequency signal according to preset attenuation.

The control module 10 is configured to output a second control signal to the gain processing module 12 when the power of the first radio frequency signal is not larger than a preset threshold.

The gain amplification module 11 is configured to amplify the gain of the first radio frequency signal by a preset multiple according to the second control signal.

The gain attenuation module 13 is configured to attenuate by 0dB the power of a signal output from the gain amplification module 11.

In a practical application, the control module 10 in the down-conversion device may be implemented by a Central Processing Unit (CPU), or a Digital Signal Processor (DSP), or a Field-Programmable Gate Array (FPGA) in the device. In a practical application, the down-conversion module 14 in the device may be implemented by a down-converter or a down-conversion circuit in the device. A sub-module of the gain processing module 12 in the device, i.e. the gain amplification module 11, may be implemented by a gain amplifier or a gain amplification circuit in the device in a practical application. A sub-module of the gain processing module 12 in the device. i.e., the gain attenuation module 13, may be implemented by a gain attenuator or a gain attenuation circuit in the device in a practical application. In a practical application, the image frequency improvement module 16 in the device may be implemented by a filter or a filter circuit in the device.

An embodiment of the disclosure further provides a realizing method of down-conversion, i.e., a working method of the aforementioned down-conversion device, which is for down-converting a first radio frequency signal received by a receiver antenna. As shown in Fig. 2, the method includes that:
step 201: the down-conversion device detects the power of a first radio frequency signal received by a receiver antenna;
step 202: the down-conversion device amplifies the gain of or attenuates the power of the first radio frequency signal according to the power of the first radio frequency signal, to obtain a second radio frequency signal; and
step 203: the down-conversion device down-converts the second radio frequency signal to an intermediate frequency and outputs an intermediate frequency signal.

In this embodiment, before the step 203, the method may further include that the down-conversion device filters the second radio frequency signal.

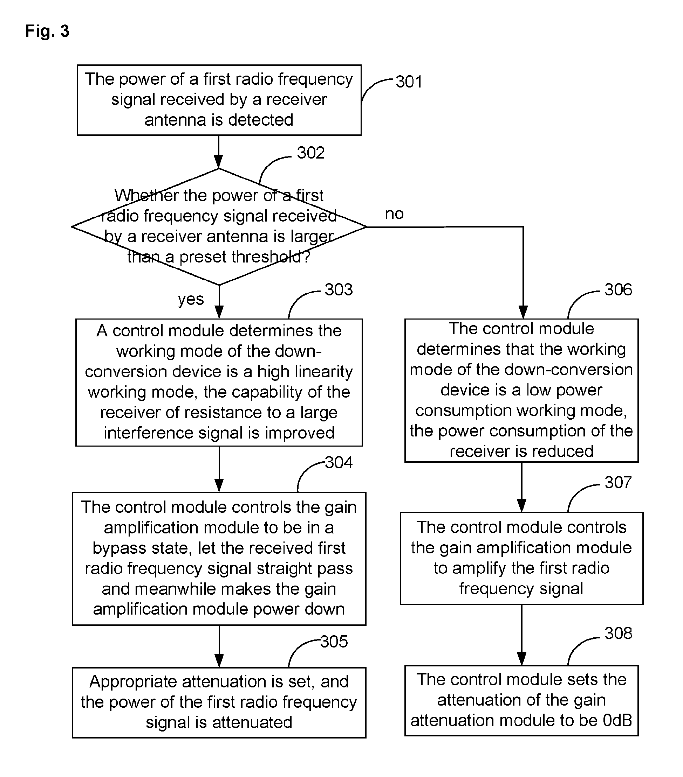

The realizing method of down-conversion applied to the down-conversion device under GSM standard according to embodiment 2 of the disclosure will be further described with reference to Fig. 3, which specifically includes the following steps:
step 301: the down-conversion device detects the power of a first radio frequency signal received by a receiver;
step 302: the down-conversion device determines whether the power of the first radio frequency signal is larger than a preset threshold; if larger, step 303 is then executed; if not larger, step 306 is then executed;
when the down-conversion device determines that the power of the first radio frequency signal is larger than a preset threshold, at which moment an interference signal received by the receiver is larger and a requirement on the linearity of the system is higher, then step 303 is executed; when the down-conversion device determines that the power of the first radio frequency signal is not larger than a preset threshold, at which moment a requirement on the linearity of the receiver is lower, then step 306 is executed;
step 303: the control module determines that the working mode of the down-conversion device is a high linearity working mode, the capability of the receiver of resistance to a strong interference signal is improved;
the control module specifically may be a Serial Peripheral Interface (SPI) control module, which is connected to the gain attenuation module and the gain amplification module through SPI, and controls a switch through SPI to switch bias circuits of the gain amplification module and the gain attenuation module to control the working states of the gain attenuation module and the gain amplification module;
step 304: the control module controls the gain amplification module to be in a bypass state, let the received first radio frequency signal straight pass and meanwhile makes the gain amplification module power down;
step 305: appropriate attenuation is set, and the power of the first radio frequency signal is attenuated;
appropriate attenuation is set according to the power of the first radio frequency signal received by a receiver antenna; a analogue-to-digital conversion module of the receiver is guaranteed to keep unsaturated; the power of the first radio frequency signal is attenuated moderately; after the power of the first radio frequency signal is attenuated to obtain a second radio frequency signal, the second radio frequency signal is down-converted to obtain an intermediate frequency signal;
step 306: the control module determines that the working mode of the down-conversion device is a low power consumption working mode, the power consumption of the receiver is reduced;
the control module specifically may be an SPI control module, which is connected to the gain attenuation module and the gain amplification module through the SPI control module, and controls a switch via the SPI control module to switch bias circuits of the gain amplification module and the gain attenuation module to control the working states of the gain attenuation module and the gain amplification module;
step 307: the control module controls the gain amplification module to amplify the first radio frequency signal; and
step 308: the control module sets the attenuation of the gain attenuation module to be 0dB; the first radio frequency signal which has been subjected to gain amplification is attenuated by 0dB to obtain a second radio frequency signal, and then the second radio frequency signal is down-converted to obtain an intermediate frequency signal.

In an embodiment, after the above steps 304 and 307 are executed, an image frequency improvement module may be used to filter a radio frequency signal which has been subjected to gain amplification, then the steps 305 and 308 are executed.

In the down-conversion device according to the embodiment of the disclosure, the gain amplification module is placed in front of the gain attenuation module. As shown in Fig. 1, when small gain is needed, the gain amplification module is directly bypassed before the gain attenuation module is appropriately adjusted, in this way, the gain will not be wasted, the linear pressure of a mixer is reduced, and a better noise factor can be obtained to improve the index of sensitivity. The device has two working modes which respectively are a low power consumption working mode and a high linearity working mode, and the different working modes may be switched by the control through SPI, so that the power consumption of the receiver is reduced. In addition, the gain dynamic of a receiver in related arts only comes from an attenuation range of a power attenuation module within the receiver, while, when the down-conversion device according to the embodiment of the disclosure is applied, the gain dynamic of the receiver includes attenuation ranges of a gain attenuation module and a gain amplification module with a bypass, thus a larger gain dynamic range is provided to the receiver. Furthermore, the down-conversion device of the disclosure applies to various standards, thus improving the integration of components, saving the costs of PCB and components, and reducing the cost of the receiver.

Another embodiment of the disclosure provides a receiver including the aforementioned down-conversion device for down-converting a radio frequency signal received by a receiver antenna.

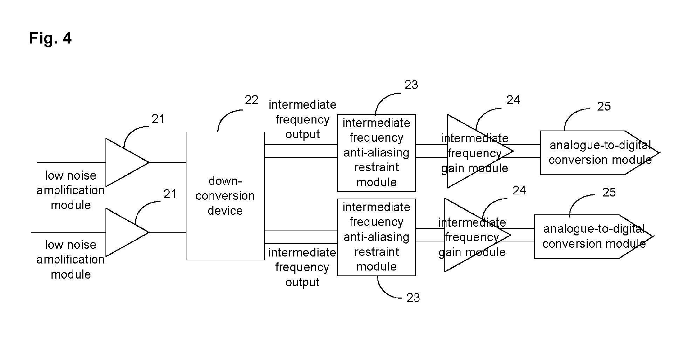

Fig. 4 is a schematic diagram showing that the down-conversion device of the disclosure is applied to a Frequency Division Duplexing (FDD) system and a Time Division Duplexing (TDD) system. As shown in Fig. 4, the down-conversion device 22 is connected to a low noise amplification module 21 and an intermediate frequency anti-aliasing restraint module 23, wherein the intermediate frequency anti-aliasing restraint module 23 is connected to an intermediate frequency gain module 24, and the intermediate frequency gain module 24 is connected to an analogue-to-digital conversion module 25.

The FDD system requires a higher index of noise factor under the sensitivity of a receiver, thus, it is needed to place a large gain low noise amplification module 21 in front of the down-conversion device 22 to guarantee that the total noise factor does not vary as other factors change. When a low power radio frequency signal is input, the down-conversion device 22 according to an embodiment of the disclosure works in a maximum gain state and in a low power consumption working mode. When a high-power interference signal is input, the bypass of the gain amplification module in the down-conversion device 22 according to an embodiment of the disclosure only performs attenuation and frequency conversion of a signal. As for the GSM standard, when a small signal is input, the down-conversion device is in a low power consumption mode; when a large intermodulation signal is input, the down-conversion device is in a high linearity working mode. As for the LTE standard and UMTS standard, the down-conversion device works in a low power consumption working mode. Thus, the requirement of the system on the index is satisfied, and the linearity and power consumption are saved.

When the down-conversion device 22 is applied to different systems, an image frequency restrain module may be used flexibly to design a link so as to satisfy the requirement. The image frequency restrain module may be placed according to the position shown in Fig. 1, or may be placed in front of the down-conversion device, to filter a radio frequency signal before the radio frequency signal enters the down-conversion device.

The down-conversion device has two application modes in the TDD system.

The first one is that since the TDD system requires lower index of gain and lower index of noise factor, thus, a single-stage Low Noise Amplifier (LNA) with gain 15dB may be placed in front of the down-conversion device 22. When a low power radio frequency signal is input, the down-conversion device 22 works in a maximum gain state, and the down-conversion module of the down-conversion device 22 may work in a low power consumption mode to satisfy the requirement of the system. When a high power radio frequency signal is input, the requirement of the TDD on the index of linearity of a system is not high, the gain amplification module of the down-conversion device is bypassed, and the down-conversion device may always work in a low power consumption mode to satisfy the requirement.

The second one is that an LNA with gain 30dB is still placed in front of the down-conversion device 22, but the gain amplification module in the down-conversion device 22 is always bypassed. When a low power radio frequency signal is input, the gain amplification module of the down-conversion device 22 is bypassed, the down-conversion module may work in a low power consumption mode. When a high power radio frequency signal is input, the gain amplification module of the down-conversion device is bypassed, the down-conversion module may still work in a low power consumption mode, wherein the gain is adjusted only through the gain attenuation module.

The down-conversion device according to the embodiment of the disclosure applies to TDD standard and FDD standard, and may satisfy a demand for a common platform of TDD and FDD. In the FDD standard, the down-conversion device according to the embodiment of the disclosure increases the bypass function of the gain amplification module, and may bypass the gain amplification module when requiring a better index of linearity of the receiver, thereby reducing the index of linearity of the gain amplifier as well as the power consumption, and meanwhile satisfying the requirement on multi-standard. The embodiments of the disclosure save the costs of PCB and components, and reduce the complexity of design while improving the integration of components through integration technology, and improve the cost advantage of a transceiver to a certain extent as well as the reliability of products.

A number of functional parts described in the description are called as modules so as to more particularly emphasize the independence of their realizing manners.

In the embodiments of the disclosure, a module may be implemented by software in order to be performed by various kinds of processors. For example, an identified executable code module may include one or more physical or logical blocks of a computer instruction, for example, the executable code module may be constructed as an object, a process or a function. Nevertheless, the executable codes of the identified module have no need to be physically located together, but may include different instructions stored in different physical places. When these instructions are logically combined, they form a module and implement a prescriptive purpose of the module.

In fact, the executable code module may be a single instruction or multiple instructions, and even may be distributed on multiple different code segments, distributed in different programs, and distributed across multiple storage devices. Similarly, operation data may be identified within a module, and may be implemented in accordance with any appropriate form and organized in a data structure of any appropriate type. The operation data may be collected as a single data set, or may be distributed in different places (including in different storage devices), and may be at least partially stored as an electronic signal only in a system or network.

If a module can be implemented using software, then in consideration of the level of the current hardware technology, those skilled in the art always can build a corresponding hardware circuit to implement the corresponding function of the module implemented by software without considering the cost, wherein the hardware circuit includes a conventional Very Large Scale Integration (VLSI) circuit or a gate array, and the conventional semiconductor such as a logic chip, a transistor and so on or other discrete element. A module may further be implemented using a programmable software device such as a field-programmable gate array, programmable array logic, a programmable logic device and so on.

In each embodiment of the method of the disclosure, the serial number of each step cannot be used for limiting the sequence of each step. As for those ordinary skilled in the art, any variation of the sequence of each step may also be included in the scope of the protection of the disclosure without any creative work.

The mentioned above are embodiments of the disclosure. It should be indicated that those ordinary skilled in the art may further make some improvement and modification without departing from the principle of the disclosure, and the improvement and modification may also be treated as the scope of the protection of the disclosure.

### INDUSTRIAL APPLICABILITY

The embodiments of the disclosure detect the power of a first radio frequency signal received by a receiver antenna, amplify the gain or attenuating the power of the first radio frequency signal according to the power of the first radio frequency signal to obtain a second radio frequency signal, down-convert the second radio frequency signal to an intermediate frequency and output an intermediate frequency signal. Thus, when an index of a multi-standard system is satisfied, it can be dynamically decided whether to amplify the gain of or attenuate the gain of radio frequency signals according to the power of different radio frequency signals received, so as to avoid attenuating a radio frequency signal before amplifying it, and reduce the power consumption of the receiver.

## Claims

1. A down-conversion device for down-converting a first radio frequency signal received by a receiver antenna, comprising:
a control module, configured to output a control signal according to power of the first radio frequency signal;
a gain processing module, configured to amplify gain of first radio frequency signal or attenuate the power of the first radio frequency signal according to the control signal, to obtain a second radio frequency signal; and
a down-conversion module, configured to down-convert the second radio frequency signal to an intermediate frequency and output an intermediate frequency signal.

2. The down-conversion device according to claim 1, further comprising:
an image frequency improvement module, configured to filter the second radio frequency signal; and
the down-conversion module, further configured to down-convert a signal output from the image frequency improvement module to an intermediate frequency, and output an intermediate frequency signal.

3. The down-conversion device according to claim 1 or 2, wherein the gain processing module comprises:
a gain amplification module, configured to amplify the gain of the first radio frequency signal or directly output the first radio frequency signal according to the control signal; and
a gain attenuation module, configured to attenuate power of a signal output from the gain amplification module according to the control signal.

4. The down-conversion device according to claim 3, wherein the control module is configured to output a first control signal to the gain processing module when the power of the first radio frequency signal is larger than a preset threshold;
the gain amplification module is configured to directly output the first radio frequency signal to the gain attenuation module according to the first control signal;
the gain attenuation module is configured to attenuate the power of the first radio frequency signal according to preset attenuation.

5. The down-conversion device according to claim 3, wherein the control module is configured to output a second control signal to the gain processing module when the power of the first radio frequency signal is no larger than a preset threshold;
the gain amplification module is configured to amplify the gain of the first radio frequency signal by a preset multiple according to the second control signal;
the gain attenuation module is configured to attenuate by 0dB the power of the signal output from the gain amplification module.

6. A receiver, comprising the down-conversion device for down-converting a radio frequency signal received by a receiver antenna according to any of claims 1 to 5.

7. A realizing method of down-conversion, which is for down-converting a first radio frequency signal received by a receiver antenna, comprising:
detecting, by a down-conversion device, power of a first radio frequency signal received by a receiver antenna;
amplifying gain of first radio frequency signal or attenuating the power of the first radio frequency signal by the down-conversion device according to the power of the first radio frequency signal, to obtain a second radio frequency signal;
down-converting, by the down-conversion device, the second radio frequency signal to an intermediate frequency and outputting an intermediate frequency signal.

8. The realizing method of down-conversion according to claim 7, further comprising:
filtering the second radio frequency signal by the down-conversion device before the down-conversion device down-converts the second radio frequency signal to an intermediate frequency.

9. The realizing method of down-conversion according to claim 7 or 8, wherein amplifying the gain of the first radio frequency signal or attenuating the power of the first radio frequency signal by the down-conversion device according to the power of the first radio frequency signal to obtain the second radio frequency signal comprises:
attenuating the power of the first radio frequency signal by the down-conversion device according to preset attenuation to obtain the second radio frequency signal when the power of the first radio frequency signal is larger than a preset threshold.

10. The realizing method of down-conversion according to claim 7 or 8, wherein amplifying the gain of the first radio frequency signal or attenuating the power of the first radio frequency signal by the down-conversion device according to the power of the first radio frequency signal to obtain the second radio frequency signal comprises:
amplifying the gain of the first radio frequency signal by a preset multiple by the down-conversion device to obtain the second radio frequency signal when the power of the first radio frequency signal is not larger than a preset threshold.
